# EUROPEAN PATENT APPLICATION

(11) **EP 4 589 667 A1**
(43) Date of publication of application: **23.07.2025**
(21) Application number: 23865844.7
(22) Date of filing: 13.09.2023
(51) Int. Cl.: H01L 33/50, H01L 33/48, H01L 33/54, H01L 33/56, H01L 25/075, F21K 9/00

(54) **LIGHT-EMITTING ELEMENT, AND LIGHTING FIXTURE HAVING SAME**

(30) Priority: 13.09.2022 US 202263405879 P
(71) Applicant: Seoul Semiconductor Co., Ltd., Gyeonggi-do 15429 (KR)
(72) Inventor: HAN, Bo Yong, Ansan-Si Gyeonggi-do 15429 (KR)
(74) Representative: Stolmár & Partner Patentanwälte PartG mbB
(86) International application number: PCT/KR2023/013724
(87) International publication number: WO 2024/058548

(57) **Abstract**

Provided are a light-emitting element and a lighting fixture having same. A light-emitting element according to one embodiment comprises: a first light-emitting diode chip emitting light having a first peak wavelength; a second light-emitting diode chip emitting light having a second peak wavelength longer than the first peak wavelength; a first wavelength conversion material that is disposed on the first light-emitting diode chip and converts the wavelength of the light emitted from the first light-emitting diode chip; and a second wavelength conversion material that is disposed on the second light-emitting diode chip and converts the wavelength of the light emitted from the second light-emitting diode chip. The peak wavelength of the excitation spectrum of the first wavelength conversion material is closer to a first peak wavelength than a second peak wavelength, and the peak wavelength of the excitation spectrum of the second wavelength conversion material is closer to the second peak wavelength than the first peak wavelength. Light that travels from the first light-emitting diode chip to the second wavelength conversion material is blocked, and light that travels from the second light-emitting diode chip to the first wavelength conversion material is blocked.

## Description

### [Technical Field]

The present disclosure relates to a light emitting device and a lighting apparatus, and more specifically, to a light emitting device using a light emitting diode as a light source and a lighting apparatus having the same.

### [Background Art]

An indoor lighting apparatus typically exhibits a constant spectral power distribution, which is significantly different from the spectral power distribution of sunlight. For example, in a case of a light emitting apparatus using blue, green, and red light emitting diodes, white light can be realized by combining blue, green, and red, but it does not exhibit a spectral power distribution over a wide wavelength range in the visible region like sunlight, but rather exhibits the distribution having peaks at specific wavelengths.

The spectrum of black body radiation such as that of the sun, is similar to that of a conventional white light source in that the higher the color temperature, the higher the intensity in the blue wavelength region. However, as the color temperature increases, the spectrum of a white light source differs markedly from the spectrum of blackbody radiation. For example, at a temperature of 6500 K, the spectrum of blackbody radiation shows a gradual decrease in intensity from a blue region to a red region.

The human eye's lens, which has adapted to the solar spectrum, can be damaged by abnormally strong light in a blue wavelength region, which might impair vision. In addition, the exposure of retinal cells to excessive energy in the blue region transmits abnormal signals to the brain, which can abnormally produce or suppress hormones such as cortisol and melatonin, which might negatively affect the body's circadian rhythm.

Recently, various studies have been conducted to provide a white light source exhibiting a spectral power distribution similar to that of the solar spectrum, but a white light source using a combination of phosphors has various drawbacks.

First, there is a drawback that the luminous efficiency of the light source decreases. Since a larger amount of phosphors needs to be wavelength-converted compared to a conventional light source, a decrease in efficiency occurs due to the wavelength conversion. Moreover, when the wavelength conversion of a green or red phosphor is performed using light of a shorter wavelength than that of blue light emitted from a blue light emitting diode, a decrease in efficiency occurs due to the Stoke's shift.

Meanwhile, the phosphors are dispersed and used in transparent a molding material such as silicone, but as the amount of phosphors used increases, it becomes difficult to block moisture using the transparent molding material. For example, silicone plays a role in preventing moisture penetration, but a decrease in a mixing ratio of silicone drastically reduces the moisture penetration prevention performance of silicone.

Further, phenyl-based silicone which is suitable for preventing moisture penetration can be easily modified by light of the shorter wavelength than blue light. Due to this, there is a disadvantage in that phenyl-based silicone cannot be used as a transparent molding material in a light emitting device using an ultraviolet or violet light emitting diode. Furthermore, when using a light emitting diode that emits light of the shorter wavelength than that of blue light, there is also a restriction on the choice of housing material.

### [Disclosure]

### [Technical Problem]

The present disclosure provides a novel technology capable of increasing luminous efficiency, for a light emitting device using various types of phosphors.

The present disclosure also provides a light emitting apparatus and a lighting apparatus that are configured to prevent or alleviate damage to a human lens or retina due to abnormal light in a blue region.

In addition, the present disclosure provides a light emitting device and a lighting apparatus having a spectral power distribution corresponding to the spectral power distribution of sunlight and configured to improve luminous efficiency and reliability thereof.

### [Technical Solution]

According to an embodiment of the present disclosure, a light emitting device includes: a first light emitting diode chip emitting light of a first peak wavelength; a second light emitting diode chip emitting light of a second peak wavelength longer than the first peak wavelength; a first wavelength conversion material disposed over the first light emitting diode chip and converting a wavelength of light emitted from the first light emitting diode chip; and a second wavelength conversion material disposed over the second light emitting diode chip and converting a wavelength of light emitted from the second light emitting diode chip. A peak wavelength of an excitation spectrum of the first wavelength conversion material may be closer to the first peak wavelength than to the second peak wavelength, and a peak wavelength of an excitation spectrum of the second wavelength conversion material may be closer to the second peak wavelength than to the first peak wavelength. Furthermore, light incident from the first light emitting diode chip to the second wavelength conversion material may be blocked, and light incident from the second light emitting diode chip to the first wavelength conversion material may be blocked.

The light emitting device may further include a third wavelength conversion material disposed over the first light emitting diode chip, and the third wavelength conversion material may convert wavelengths of light emitted from the first light emitting diode chip and light emitted from the first wavelength conversion material. A peak wavelength of an excitation spectrum of the third wavelength conversion material may be closer to a peak wavelength of an emission spectrum of the first wavelength conversion material than to the first peak wavelength.

In an embodiment, the first wavelength conversion material may be a blue phosphor, the second wavelength conversion material may be a green or yellow phosphor, and the third wavelength conversion material may be a red phosphor.

In an embodiment, the first peak wavelength may be in a range of 410 nm to 440 nm, and the second peak wavelength may be in a range of 440 nm to 470 nm.

The light emitting device may further include a first housing having a first cavity and a second housing having a second cavity. The first light emitting diode chip may be disposed in the first cavity of the first housing, the second light emitting diode chip may be disposed in the second cavity of the second housing, and the first cavity and the second cavity may be spaced apart from each other.

In an embodiment, the first housing may be formed of an epoxy molding compound, and the second housing may be formed of Polyester Polycyclohexylenedimethylene Terephthalate (PCT).

The light emitting device may further include a first molding member disposed in the first cavity and a second molding member disposed in the second cavity. The first wavelength conversion material may be distributed in the first molding member, and the second wavelength conversion material may be distributed in the second molding member.

Furthermore, the first molding member may include silicone with methyl-based silicone as a main component, and the second molding member may include silicone with phenyl-based silicone as a main component.

The light emitting device may further include a third wavelength conversion material disposed in the first molding member. The third wavelength conversion material may convert wavelengths of light emitted from the first light emitting diode chip and light emitted from the first wavelength conversion material, and a peak wavelength of an excitation spectrum of the third wavelength conversion material may be closer to the peak wavelength of the emission spectrum of the first wavelength conversion material than to the first peak wavelength.

Furthermore, a peak wavelength of an emission spectrum of the third wavelength conversion material may be longer than a peak wavelength of an emission spectrum of the second wavelength conversion material.

In an embodiment, the first wavelength conversion material may be a blue phosphor, the second wavelength conversion material may be a green or yellow phosphor, and the third wavelength conversion material may be a red phosphor.

The first housing may be coupled to the second housing.

In an embodiment, the first housing may be surrounded by the second housing.

In another embodiment, the first housing may be spaced apart from the second housing.

In an embodiment, the first housing and the second housing may have a same area. In another embodiment, the first housing and the second housing may have different areas from each other.

According to an embodiment of the present disclosure, a light emitting device may include: a first light emitting unit including a first light emitting diode chip and a first wavelength conversion material; and a second light emitting unit including a second light emitting diode chip and a second wavelength conversion material. The first light emitting diode chip may emit light of a first peak wavelength, and the second light emitting diode chip may emit light of a second peak wavelength that is longer than the first peak wavelength. Furthermore, the first light emitting unit may emit a first mixed color light having a color coordinate positioned below the Planckian locus on a CIE color coordinate system, the second light emitting unit may emit a second mixed color light having a color coordinate positioned above the Planckian locus on the CIE color coordinate system, and the light emitting device may emit light in which the first mixed color light and the second mixed color light are mixed.

Moreover, the first light emitting unit may further include a third wavelength conversion material. The third wavelength conversion material may convert wavelengths of light emitted from the first light emitting diode chip and light emitted from the first wavelength conversion material, and a peak wavelength of an excitation spectrum of the third wavelength conversion material may be closer to a peak wavelength of an emission spectrum of the first wavelength conversion material than to the first peak wavelength.

The first wavelength conversion material may be a blue phosphor, the second wavelength conversion material may be a green or yellow phosphor, and the third wavelength conversion material may be a red phosphor.

A lighting apparatus according to an embodiment of the present disclosure includes the light emitting device described above.

### [Description of Drawings]

FIG. 1 is a graph showing a typical emission spectral distribution of a green or yellow garnet-based phosphor.
FIG. 2 is a graph showing a typical excitation spectral distribution of the green or yellow garnet-based phosphor.
FIG. 3 is a graph showing a typical emission spectral distribution of a red CASN-based phosphor.
FIG. 4 is a graph showing a typical excitation spectral distribution of the red CASN-based phosphor.
FIG. 5 is a graph showing a typical emission spectral distribution of a blue halophosphate phosphor.
FIG. 6 is a graph showing a typical excitation spectral distribution of the blue halophosphate phosphor.
FIG. 7 is a graph showing an external quantum efficiency of an InGaN-based light emitting diode according to a typical wavelength.
FIG. 8A is a schematic plan view illustrating a light emitting device according to an embodiment of the present disclosure.
FIG. 8B is a schematic cross-sectional view taken along line A-A' of FIG. 8A.
FIG. 9 is a graph showing emission spectral distributions of light emitting devices according to Embodiment 1 and Comparative Example 1.
FIG. 10 is a graph showing emission spectral distributions of light emitting devices according to Embodiment 2 and Comparative Example 2.
FIG. 11 is a graph showing emission spectral distributions of light emitting devices according to Embodiment 3 and Comparative Example 3.
FIG. 12 is a graph illustrating a method of implementing color coordinates of a light emitting device according to embodiments of the present disclosure.
FIG. 13 is a schematic plan view illustrating a light emitting device according to another embodiment of the present disclosure.
FIG. 14 is a schematic plan view illustrating a light emitting device according to another embodiment of the present disclosure.
FIG. 15 is a schematic plan view illustrating a light emitting device according to another embodiment of the present disclosure.

### [Best Mode]

Hereinafter, exemplary embodiments of the present disclosure will be described in detail with reference to the accompanying drawings. The following exemplary embodiments presented hereinbelow are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of elements may be exaggerated for convenience of descriptive purposes. Throughout the specification, like reference numerals denote like elements having the same or similar functions.

Hereinafter, unless otherwise specified, a specific color coordinate refers to a color coordinate in the CIE-1931 coordinate system defined by the American National Standards Institute (ANSI).

To implement a white spectral distribution similar to that of sunlight, it is very important to control an emission intensity of a spectral distribution corresponding to a blue region to a level of sunlight corresponding to the blue region. However, it is very difficult to implement a white region for each correlated color temperature on the CIE-1931 xy color coordinate system while properly controlling a high emission intensity in the blue region to the level of sunlight using a blue light emitting diode chip. To effectively control the emission intensity of the blue region to the level of sunlight when implementing the white spectral distribution, it is advantageous to have a relatively wide and gentle spectral distribution exhibiting blue rather than a narrow and strong distribution, however, a method of implementing the white spectral distribution based on a conventional blue light emitting diode chip has difficulty in properly controlling the high emission intensity of the blue region to the level of sunlight due to the narrow and strong spectral distribution emitted from the blue light emitting diode.

Therefore, to implement the white region for each correlated color temperature on the CIE-1931 xy color coordinate system while maintaining the blue spectral distribution to the level of sunlight, there is a need for a novel light source that is capable of exhibiting a much wider and gentler spectral distribution than that of the blue light emitting diode chip that has the narrow and strong spectral distribution for exhibiting the blue region, and a wavelength conversion material using the same.

Three primary colors of light are blue, green, and red, and when these three colors are mixed, white is exhibited. When the blue light emitting diode chip is applied, wavelength conversion materials corresponding to green and red are further required, and a specific spectral distribution may be implemented by additive mixing of spectral distributions of each of the green and red wavelength conversion materials and blue light.

Meanwhile, when applying a near-ultraviolet light emitting diode chip that emits visible light close to ultraviolet light, for example violet light, a wavelength conversion material for exhibiting blue is further required in addition to the wavelength conversion materials corresponding to green and red, and blue, green, and red light emitted from phosphors may be additively mixed with near-ultraviolet light to implement the specific spectral distribution. In both cases of applying the blue light emitting diode chip or the near-ultraviolet light emitting diode chip, a spectral distribution design is required to adjust optical characteristics by additively mixing the wavelength conversion materials with appropriate emission spectra required for implementing the white spectral distribution.

Embodiments of the present disclosure disclose a novel method for improving a luminous efficiency of a light emitting device using several types of phosphors. A phosphor has an excitation spectral distribution along with an emission spectral distribution. When light of a wavelength with a high intensity in the spectral distribution is irradiated onto the phosphor, the phosphor can absorb excited light and emit wavelength-converted light with high efficiency. Alternatively, when light of a wavelength with a low intensity in the excitation spectral distribution is irradiated onto the phosphor, the phosphor will absorb excited light and emit wavelength-converted light with low efficiency.

First, typical emission spectral distribution and excitation spectral distribution of each phosphor will be described.

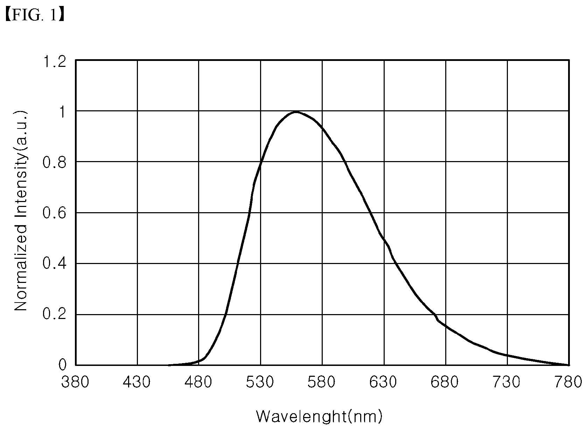

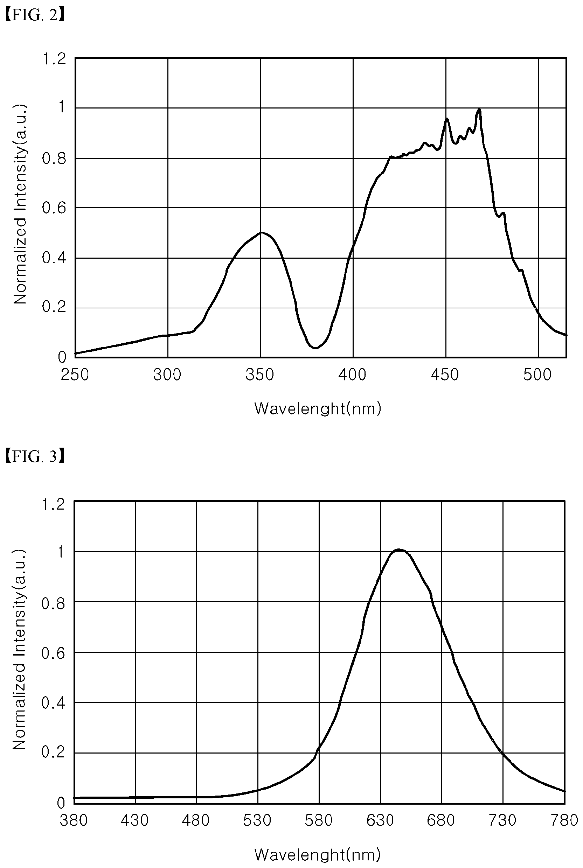

FIG. 1 is a graph showing a typical emission spectral distribution of a green or yellow garnet-based phosphor, and FIG. 2 is a graph showing a typical excitation spectral distribution of the green or yellow garnet-based phosphor. FIG. 1 shows an emission spectral distribution of a phosphor by excitation light having a wavelength of 450 nm, and FIG. 2 shows an emission intensity of the phosphor at 540 nm according to a wavelength of excitation light.

Generally, the green or yellow phosphor has an emission spectral distribution with a peak wavelength in a range of 500 nm to 600 nm. Such a phosphor has an excitation spectral distribution with a peak wavelength in a range of 450 nm to 470 nm, as illustrated in FIG. 2. That is, the green or yellow phosphor converts blue excitation light in the wavelength range of 450 nm to 470 nm into green or yellow light with optimal efficiency. Meanwhile, the green or yellow phosphor has a low intensity in the excitation spectrum for light in a wavelength range of about 420 nm or less, and thus, has considerably low wavelength conversion efficiency.

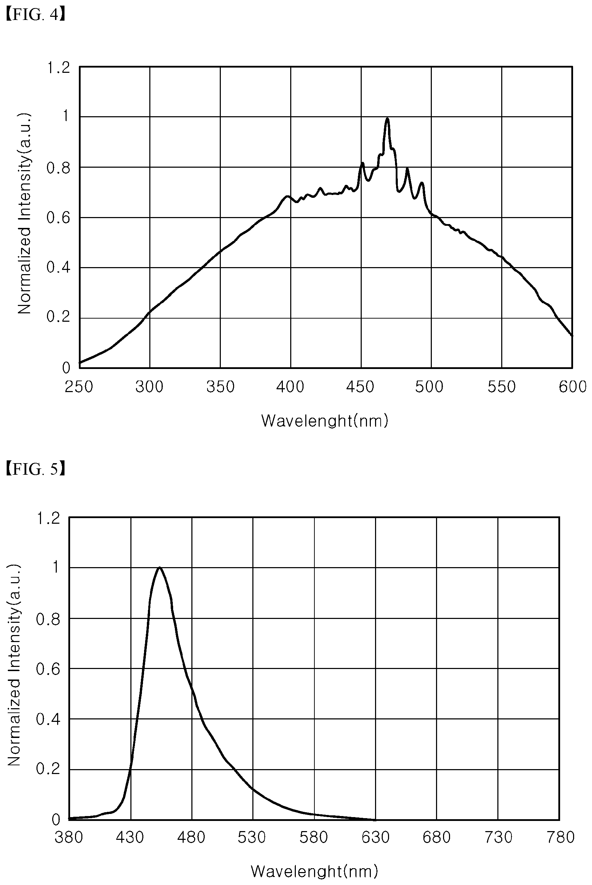

FIG. 3 is a graph showing a typical emission spectral distribution of a red CASN-based phosphor, and FIG. 4 is a graph showing a typical excitation spectral distribution of the red CASN-based phosphor. FIG. 3 shows an emission spectral distribution of a phosphor by excitation light having a wavelength of 450 nm, and FIG. 4 shows an emission intensity of the phosphor at 645 nm according to a wavelength of excitation light.

Generally, a red phosphor has an emission spectral distribution with a peak wavelength in a range of 600 nm to 680 nm. Such a phosphor has an excitation spectral distribution with a peak wavelength in a range of 400 nm to 500 nm, as illustrated in FIG. 4. That is, the red phosphor converts excitation light in a wavelength range of 400 nm to 500 nm into red light with optimal efficiency. Meanwhile, the red phosphor has low intensity of the excitation spectrum for light in a wavelength range of about 500 nm or more, and thus, has considerably low wavelength conversion efficiency.

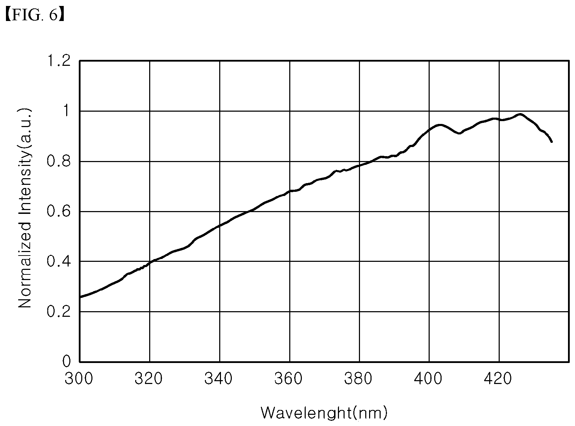

FIG. 5 is a graph showing a typical emission spectral distribution of a blue halo phosphate-based phosphor, and FIG. 6 is a graph showing a typical excitation spectral distribution of the blue halo phosphate-based phosphor.

Generally, a blue phosphor has an emission spectral distribution with a peak wavelength in a range of 440 nm to 480 nm. Such a phosphor has an excitation spectral distribution with a peak wavelength in a range of 400 nm to 425 nm, as illustrated in FIG. 6. That is, the blue phosphor converts excitation light in a wavelength range of 400 nm to 425 nm into blue light with optimal efficiency. Meanwhile, in the blue phosphor, an intensity of the excitation spectrum decreases rapidly as a wavelength thereof increases for light in a wavelength range of about 425 nm or more.

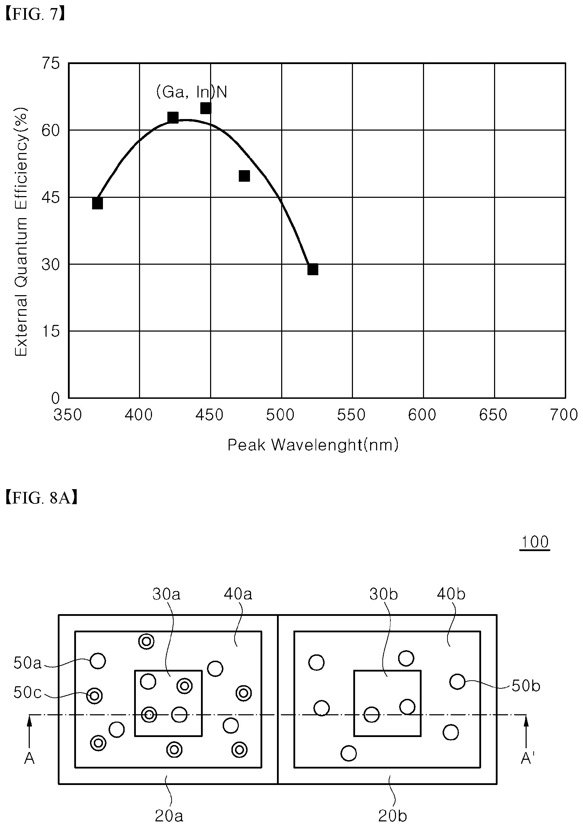

FIG. 7 is a graph showing an external quantum efficiency of an InGaN-based light emitting diode according to a typical wavelength.

Referring to FIG. 7, it can be confirmed that the InGaN-based light emitting diode has a relatively high external quantum efficiency in a wavelength range of approximately 390 nm to 470 nm and a low external quantum efficiency in a region outside the above wavelength range. When using a light emitting diode as a light source, a light emitting diode with a peak wavelength in the above range is generally selected considering luminous efficiency.

For example, a blue light emitting diode may be used together with a green or yellow phosphor and a red phosphor to achieve the white spectral distribution. As described with reference to FIGs. 2 and 4, the blue light emitting diode is suitable as an excitation light source for the above phosphors. That is, it can be confirmed that both the green or yellow phosphor and the red phosphor have strong excitation spectral distributions around 450 nm, and thus, a desired spectral distribution may be designed with optimal efficiency by applying a blue light emitting diode chip.

However, as described above, white light by a combination of the blue light emitting diode and phosphors exhibits excessively high emission intensity in a blue region, as illustrated in FIG. 2, and thus, has a spectral distribution different from that of white light similar to sunlight. To solve this, a near-ultraviolet light emitting diode may be used as a light source, and a wavelength conversion material, that is, a blue phosphor, is further required to express blue color.

Meanwhile, a wavelength of the near-ultraviolet light emitting diode is selected to excite blue, green or yellow, and red phosphors used together with the near-ultraviolet light emitting diode. In selecting the wavelength of the near-ultraviolet light emitting diode to be emitted, since the blue region is exhibited by a wavelength conversion material, the wavelength of light emitted from the near-ultraviolet light emitting diode should not be a main emission wavelength in the blue region, and an efficiency of a radiant power of the light emitting diode chip expressed in mW should be maximized, in addition, a physical deterioration phenomenon of components forming the light emitting device should be minimized, and furthermore, any adverse effects on the human body should also be considered.

First, a peak wavelength of light emitted from the near-ultraviolet light emitting diode needs to be 440 nm or less to excite the blue phosphor without becoming a main emission wavelength in the blue region. In addition, to maximize the efficiency of the radiant power of the light emitting diode expressed in mW, the peak wavelength of the near-ultraviolet light emitting diode, as it can be seen from FIG. 7, may be 390 nm or more, further, 400 nm or more, furthermore, 410 nm or more. For example, the near-ultraviolet light emitting diode may exhibit favorable radiation efficiency in a range of 400 nm to 430 nm.

Meanwhile, the phosphor which corresponds to the wavelength conversion material is typically excited by light in a high energy range and emits light in a low energy range based on a physical law. And, such a phosphor, when an ion corresponding to an emission center among components forming the phosphor receives energy corresponding to an excitation energy, goes through an energy loss process expressed as Stoke's shift and emits light with energy lower than that of the excitation energy. In addition, a quantum efficiency of the phosphor is maximized when the excitation energy and emission energy have a certain gap. That is, it means that it is necessary to select a phosphor that can draw maximum efficiencies of an excitation wavelength and an emission wavelength by considering Stoke's shift characteristics of the phosphor itself.

The emission spectral distribution and the excitation spectral distribution of the halo phosphate-based phosphor, which is a representative blue region wavelength conversion material, are shown in FIGs. 5 and 6. Referring to the excitation spectral distribution in FIG. 6, it can be confirmed that the efficiency of the excitation spectral distribution decreases rapidly as the wavelength increases beyond 420 nm.

Therefore, when applying the near-ultraviolet light emitting diode, the emission wavelength of the near-ultraviolet light emitting diode, and phosphors, the blue phosphor, as well as the green or yellow phosphor and the red phosphor, should be selected to implement the white spectral distribution through interaction with the phosphors and to optimize a luminous efficiency compared to an applied electrical energy, that is, a luminous efficiency of the light emitting device expressed in lm/W.

A conventional technique using the near-ultraviolet light emitting diode as the light source uses a mixture of the blue phosphor, the green or yellow phosphor, and the red phosphor together with the near-ultraviolet light emitting diode. That is, the near-ultraviolet light emitting diodes is used as excitation light source for the blue phosphor, the green or yellow phosphor, and the red phosphor.

However, referring again to FIGs. 1 and 2, which show an emission spectral distribution and an excitation spectral distribution of a YAG phosphor, a representative wavelength conversion material in a green or yellow region described above, an efficiency in a 400 to 420 nm region in the excitation spectral distribution of the YAG phosphor, which corresponds to the wavelength of the near-ultraviolet light emitting diode to be emitted, drops sharply compared to that of a blue wavelength region of 450 to 460 nm. That is, Stoke's shift characteristics of the YAG phosphor, the wavelength conversion material in the green or yellow region, are not suitable for wavelength conversion with maximum efficiency by applying the near-ultraviolet light emitting diode.

In addition, it is conceivable that the near-ultraviolet light emitting diode excites the blue phosphor to emit blue light, and blue light emitted from the blue phosphor excites the green or yellow phosphor, however, even in this case, since an energy of light emitted from the near-ultraviolet light emitting diode has energy loss from the blue phosphor and then again energy loss from the green or yellow phosphor, it is not possible to prevent a decrease in energy conversion efficiency.

Meanwhile, when looking at excitation and emission spectral distributions of a CASN-based red phosphor shown in FIGs. 3 and 4, a main emission wavelength of the red phosphor is positioned at approximately 640 nm to 650 nm. However, referring to FIG. 2, which shows a white spectral distribution implemented based on the blue light emitting diode chip, it can be confirmed that as a color temperature thereof increases, a wavelength having a maximum emission distribution in a red region shifts to around 630 nm. A reason why the main emission wavelength of the red wavelength-converted CASN-based phosphor differs from a main emission wavelength of the white spectral distribution is due to an energy interaction between the phosphors, which is expected for the following reasons when looking at this in detail.

That is, in a case of a white spectral distribution implementation method based on the blue light emitting diode, light emitted from the blue light emitting diode is first absorbed simultaneously by the green or yellow phosphor and the red phosphor, and then converted light is emitted through an energy conversion process. The red phosphor absorbs an energy emitted from the blue light emitting diode, while also absorbing an energy emitted from the green or yellow phosphor, and red light is emitted through an appropriate energy conversion process. Looking at the excitation spectral distribution of the red phosphor illustrated in FIG. 4, it overlaps significantly with the emission spectral distribution of the green or yellow phosphor illustrated in FIG. 1. That is, the red phosphor absorbs not only the energy emitted from the blue light emitting diode, but also the energy emitted from the green or yellow phosphor, resulting in an energy interference between the green or yellow phosphor and the red phosphor. Accordingly, in the white spectral distribution for each correlated color temperature as shown in FIG. 2, the green or yellow and red phosphors do not exhibit an emission spectral distribution that they originally have, but the emission distribution shifts to a region between green or yellow and red from the original emission distribution.

Therefore, in addition to a conversion efficiency of converting a wavelength of light emitted from the light source such as the blue light emitting diode or the near-ultraviolet light emitting diode by the red phosphor, a conversion efficiency of converting a wavelength of light emitted from the green or yellow phosphor by the red phosphor has also to be considered.

Hereinafter, a light emitting device according to embodiments of the present disclosure in which a luminous efficiency thereof is maximized will be described in detail with reference to the drawings.

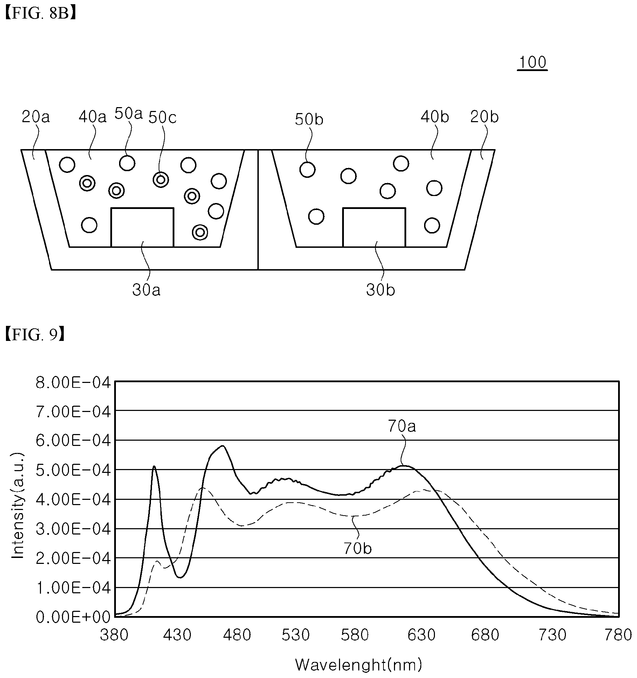

FIG. 8A is a schematic plan view illustrating a light emitting device 100 according to an embodiment of the present disclosure, and FIG. 8B is a schematic cross-sectional view taken along line A-A' of FIG. 8A.

Referring to FIGs. 8A and 8B, the light emitting device 100 according to an embodiment of the present disclosure includes two light emitting units. For example, a first light emitting unit may include a first housing 20a, a first light emitting diode chip 30a, a first molding member 40a, a first wavelength conversion material 50a, and a third wavelength conversion material 50c. A second light emitting unit may include a second housing 20b, a second light emitting diode chip 30b, a second molding member 40b, and a second wavelength conversion material 50b.

The first housing 20a and the second housing 20b may be disposed adjacent to each other, and may be coupled to each other. For example, the first and second housings 20a and 20b may be formed of an epoxy molding compound (EMC), a silicone molding compound (SMC), a Polyester Polycyclohexylenedimethylene Terephthalate (PCT), or a ceramic. The EMC has favorable light resistance and impact resistance, especially in the light emitting device 100 including light emitting diode chips of short-wavelength light sources. Therefore, as an example, the first and second housings 20a and 20b may be formed of the EMC. However, the inventive concepts are limited thereto. For example, the first housing 20a may be formed of the EMC, and the second housing 20b may be formed of the PCT. Since the PCT has a high reflectivity for blue light, it may be suitably used in the housing in which the second light emitting diode chip 30b of 440 nm or more is mounted.

The first light emitting diode chip 30a may emit light having a first peak wavelength in a range of about 410 nm to about 440 nm. The first light emitting diode chip 30a may be formed of a gallium nitride semiconductor layer. The first light emitting diode chip 30a may be mounted within a cavity of the first housing 20a.

The second light emitting diode chip 30b emits light with a longer wavelength than that of the first light emitting diode chip 30b. The second light emitting diode chip 30b may emit light having a second peak wavelength in a range of, for example, 440 nm to 470 nm. The second light emitting diode chip 30b may be mounted within a cavity of the second housing 20b.

The first molding member 40a covers the first light emitting diode chip 30a. The first molding member 40a may fill the cavity of the first housing 20a. The first molding member 40a may include the wavelength conversion materials 50a and 50c. The first molding member 40a may include silicone. For example, the first molding member 40a may be formed of high refractive index silicone containing a large amount of phenyl-based silicone together with methyl-based silicone, or medium refractive index silicone containing a small amount of phenyl-based silicone in methyl-based silicone, or low refractive index silicone containing no phenyl-based silicone at all in methyl-based silicone. The methyl-based silicone has superior light resistance to short-wavelength light such as near-ultraviolet rays and also has superior impact resistance compared to the phenyl-based silicone. Therefore, the first molding member 40a includes the methyl-based silicone as a main component, and may also include the phenyl-based silicone, but a content of the phenyl-based silicone needs to be appropriately controlled, may be, for example, 10 wt% or less of the methyl-based silicone.

The second molding member 40b covers the second light emitting diode chip 30b. The second molding member 40b may fill the cavity of the second housing 20b. The second molding member 40b may include the wavelength conversion material 50b. The second molding member 40b may include silicone. For example, the second molding member 40b may contain a larger amount of the phenyl-based silicone compared to the first molding member 40a. The second molding member 40b may have a higher refractive index than that of the first molding member 40a. Since the phenyl-based silicon has a relatively high refractive index, a light extraction efficiency of the light emitting diode chip 30b may be maximized.

The first wavelength conversion material 50a converts a wavelength of light emitted from the first light emitting diode chip 30a. The first wavelength conversion material 50a may have a peak wavelength that is longer than that of the first peak wavelength. For example, the first wavelength conversion material 50a may be a blue phosphor. An example of the blue phosphor may include a BAM-based, Halo-Phosphate-based or aluminate-based phosphor, for example, BaMgAl₁₀O₁₇:Mn²⁺, BaMgAl₁₂O₁₉:Mn²⁺ or (Sr,Ca,Ba)PO₄Cl:Eu²⁺. The first wavelength conversion material 50a is not limited to a phosphor, and may be a quantum dot or a perovskite, or the like. The first wavelength conversion material 50a may have the peak wavelength in a range of, for example, 440 to 500 nm.

The second wavelength conversion material 50b converts a wavelength of light emitted from the second light emitting diode chip 30b. The second wavelength conversion material 50b may have a peak wavelength that is longer than that of the second peak wavelength. For example, the second wavelength conversion material 50b may be a green or yellow phosphor. An example of the green or yellow phosphor may include LuAG(Lu₃(Al,Gd)₅O₁₂:Ce³⁺), YAG(Y₃(Al,Gd)₅O₁₂:Ce³⁺), Ga-LuAG((Lu,Ga)₃(Al,Gd)₅O₁₂:Ce³⁺), Ga-YAG ((Ga,Y)₃(Al,Gd)₅O₁₂:Ce³⁺), LuYAG ((Lu,Y)₃(Al,Gd)₅O₁₂:Ce³⁺), Ortho-Silicate ((Sr,Ba,Ca,Mg)₂SiO₄:Eu²⁺), Oxynitride ((Ba,Sr,Ca)Si₂O₂N₂:Eu²⁺), Thio Gallate (SrGa₂S₄:Eu²⁺), or the like. The second wavelength conversion material 50b may also be a quantum dot or a perovskite. The second wavelength conversion material 50b may have the peak wavelength in a range of, for example, 500 nm to 600 nm.

A peak wavelength of an excitation spectrum of the second wavelength conversion material 50b is closer to the second peak wavelength of the second light emitting diode chip 30b than to the first peak wavelength of the first light emitting diode chip 30a. Therefore, when the second wavelength conversion material 50b is excited with light emitted from the second light emitting diode chip 30b, compared to when the second wavelength conversion material 50b is excited with light emitted from the first light emitting diode chip 30a, a luminous efficiency may be increased, and a light loss due to the Stoke's shift may be reduced.

The third wavelength conversion material 50c may convert wavelengths of light emitted from the first light emitting diode chip 30a and the first wavelength conversion material 50a. The third wavelength conversion material 50c may emit light having a peak wavelength that is longer than that of the second wavelength conversion material 50b. For example, the third wavelength conversion material 50c may be a red phosphor. An example of the red phosphor may include a phosphor of Nitride-, Sulfide-, Fluoride-, Oxyfluoride- or Oxynitride-based, and specifically, CASN (CaAlSiN₃:Eu²⁺), (Ba,Sr,Ca)₂Si₅N₈:Eu²⁺, (Ca,Sr)S₂:Eu²⁺), (Sr,Ca)₂SiS₄:Eu²⁺, or the like. The third wavelength conversion material 50c may also be a quantum dot or a perovskite. The third wavelength conversion material 50c may have a peak wavelength in a range of, for example, 600 nm to 700 nm.

A peak wavelength of an excitation spectrum of the third wavelength conversion material 50c may be closer to the peak wavelength of the first wavelength conversion material 50a than to the first peak wavelength of the first light emitting diode chip 30a. Accordingly, light emitted from the first light emitting diode chip 30a is converted in the first wavelength conversion material 50a, and even after light emitted from the first wavelength conversion material 50a is converted again in the third wavelength conversion material 50c, an efficiency reduction may be reduced.

Meanwhile, to prevent light emitted from the first light emitting diode chip 30a from exciting the second wavelength conversion material 50b in the second housing 20b, the second wavelength conversion material 50b is disposed outside a path of light emitted from the first light emitting diode chip 30a. In addition, to prevent light emitted from the second light emitting diode chip 30b from exciting the first and third wavelength conversion materials 50a and 50c in the first housing 20a, the first and third wavelength conversion materials 50a and 50c are disposed outside a path of light emitted from the second light emitting diode chip 30b. To do this end, the cavity of the first housing 20a and the cavity of the second housing 20b may be separated from each other by a partition.

According to the embodiment of the present disclosure, the light emitting device 100 is provided, which is configured to realize stronger white light by having a higher luminous efficiency even when implementing white light of a same color temperature under a same input power. That is, lm/W, which represents the luminous efficiency output compared to an applied electric energy, may be maximized.

In this embodiment, although it has been described that the first to third wavelength conversion materials 50a, 50b, and 50c are disposed to implement white light, but the inventive concepts are not limited thereto. That is, the present disclosure may be applied to a light emitting device using two or more types of wavelength conversion materials having different excitation spectra and emission spectra, and these two or more types of wavelength conversion materials are excited by light emitting diode chips having different peak wavelengths from one another. Therefore, optical loss due to the Stoke's shift may be reduced, and the wavelength conversion may be performed with optimal efficiency for each wavelength conversion material. Moreover, it is possible to select a housing material and a molding material suitable for each light emitting diode chip, thereby further improving a reliability and luminous efficiency of the light emitting device.

Meanwhile, in this embodiment, although it has been described that main wavelength conversion materials 50a, 50b, and 50c are disposed in the first and second housings 20a and 20b, in addition to these wavelength conversion materials 50a, 50b, and 50c, other wavelength conversion materials may be further added to the first housing 20a and/or the second housing 20b. For example, a Mn⁴⁺-activated fluoride phosphor may be added to the first housing 20a or the second housing 20b.

White light emitting devices using conventional near-ultraviolet light emitting diodes at various color temperatures and white light emitting devices according to embodiments of the present disclosure were manufactured, and a relative luminance, a color coordinate, a correlated color temperature (CCT), and an average color rendering index (CRI) are shown in Table 1.

**[Table 1]**

| | Current (mA) | Relative luminance (%) | CIE-x | ICD-10 | CCT(K) | CRI |
|---|---|---|---|---|---|---|
| Comparative Example 1 | 100 | 100 | 0.346 | 0.344 | 4932 | 93.7 |
| Embodiment Example 1 | A:59 | 120 | 0.342 | 0.351 | 5118 | 93.0 |
| | B:41 | | | | | |
| Comparative Example 2 | 100 | 100 | 0.382 | 0.366 | 3888 | 92.2 |
| Embodiment Example 2 | A:60 | 125 | 0.383 | 0.364 | 3832 | 93.3 |
| | B:40 | | | | | |
| Comparative Example 3 | 100 | 100 | 0.425 | 0.392 | 3108 | 94.3 |
| Embodiment Example 3 | A:63 | 130 | 0.428 | 0.394 | 3075 | 92.2 |
| | B:37 | | | | | |
| Comparative Example 4 | 100 | 100 | 0.459 | 0.395 | 2579 | 90.9 |
| Embodiment Example 4 | A:70 | 133 | 0.460 | 0.395 | 2576 | 91.4 |
| | B:30 | | | | | |

Conventional light emitting devices were manufactured using a single light emitting diode chip and a blue phosphor, a green or yellow phosphor, and a red phosphor, and emitted white light having correlated color temperatures of Comparative Examples 1 to 4 under a driving current of 100 mA.

White light emitting devices of the present disclosure include a first light emitting diode chip and a second light emitting diode chip disposed in a first housing and a second housing, respectively, a blue phosphor and a red phosphor disposed in the first housing, and a green or yellow phosphor disposed in the second housing, which were driven such that a sum of driving currents of the first light emitting diode chip and the second light emitting diode chip becomes 100 mA, thereby emitting white light having correlated color temperatures similar to those of the conventional light emitting devices. Both the first light emitting diode chip and the conventional single light emitting diode chip have peak wavelengths between about 410 nm and 440 nm, and the second light emitting diode chip has a peak wavelength between about 440 nm and 470 nm.

Referring to Table 1, under the condition with the same amount of total current, the light emitting devices of the Comparative Example 1 and the Embodiment Example 1 realized white light having a correlated color temperature of approximately 5000 K, but the light emitting device of the Embodiment Example 1 showed a luminance 20% higher than that of the light emitting device of the Comparative Example 1. The light emitting devices of the Comparative Example 2 and the Embodiment Example 2 realized white light having a correlated color temperature of approximately 4000 K, but the light emitting device of the Embodiment Example 2 showed a luminance 25% higher than that of the light emitting device of the Comparative Example 2. In addition, the light emitting devices of the Comparative Example 3 and the Embodiment Example 3 realized white light having a correlated color temperature of approximately 3000 K, but the light emitting device of the Embodiment Example 3 showed a luminance that was 30% higher than that of the light emitting device of the Comparative Example 3, and the light emitting devices of the Comparative Example 4 and the Embodiment Example 4 realized white light having a correlated color temperature of approximately 2700 K, but the light emitting device of the Embodiment Example 4 showed a luminance that was approximately 34% higher than that of the light emitting device of the Comparative Example 4.

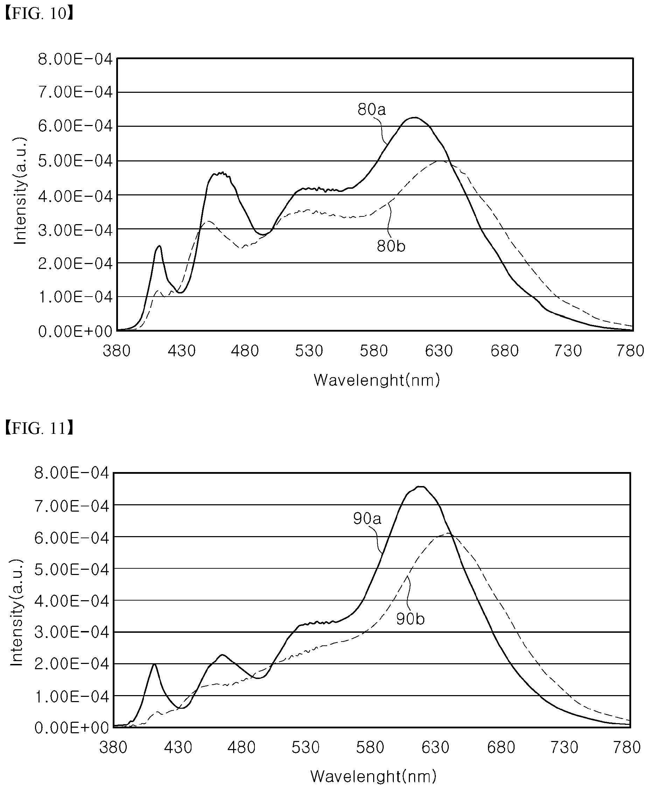

FIG. 9 is a graph showing emission spectral distributions of the light emitting devices according to the Embodiment Example 1 and the Comparative Example 1, FIG. 10 is a graph showing emission spectral distributions of the light emitting devices according to the Embodiment Example 2 and the Comparative Example 2, and FIG. 11 is a graph showing emission spectral distributions of the light emitting devices according to the Embodiment Example 4 and the Comparative Example 4.

Referring to FIGs. 9, 10, and 11, it can be confirmed that the light emitting devices of the embodiments exhibit similar emission spectral distributions to those of the light emitting devices of the comparative examples, but exhibit relatively higher emission intensities in most wavelength ranges of a visible region. Moreover, in the light emitting devices of the embodiments, by disposing the red phosphor together with the blue phosphor, a peak wavelength in a red region shifts to a shorter wavelength side compared to the conventional light emitting devices, and accordingly, overall brightnesses of the light emitting devices may be further increased.

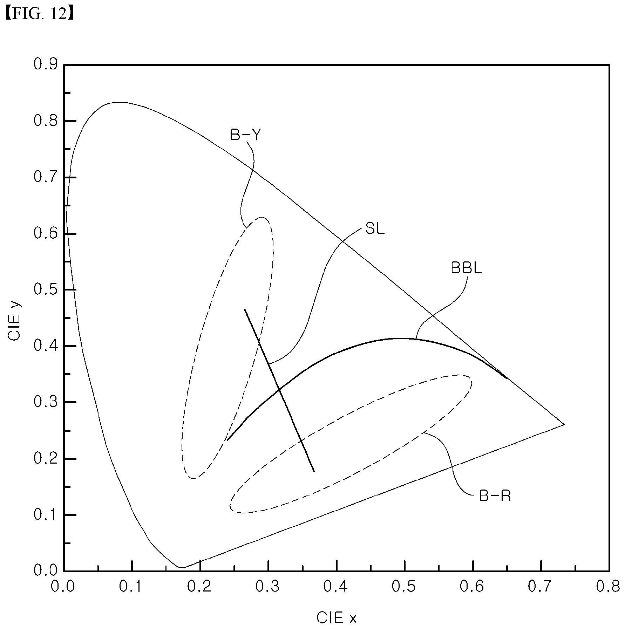

FIG. 12 is a graph illustrating a method of implementing color coordinates of a light emitting device according to embodiments of the present disclosure.

A light emitting device 100 according to these embodiments emits two mixed color lights having color coordinates within a first region B-R and a second region B-Y, and implements a final target mixed color light through mixing these two mixed color lights. The first region B-R may be positioned below a Planckian locus PL, and the second region B-Y may be positioned above the Planckian locus PL. For example, a first light emitting unit including a first light emitting diode chip 30a, a blue phosphor 50a and a red phosphor 50c is used to emit a first mixed light having the color coordinate within the first region B-R, and a second light emitting unit including a second light emitting diode chip 30b and a green or yellow phosphor 50b is used to emit a second mixed light having the color coordinate within the second region B-Y. The first mixed light and the second mixed light may be mixed to implement light of required color coordinates. The color coordinates and intensities of the first mixed light and the second mixed light may be adjusted such that the final mixed light has color coordinates on the Planckian locus line. For example, white light having a desired color temperature may be implemented by adjusting the color coordinate within the first region B-R and the color coordinate within the second region B-Y and their intensities.

In these embodiments, the light emitting device 100 that implements white light of the desired color temperature is described, but the inventive concepts are not limited to white light, and the light emitting device 100 may implement another mixed color light such as cyan light.

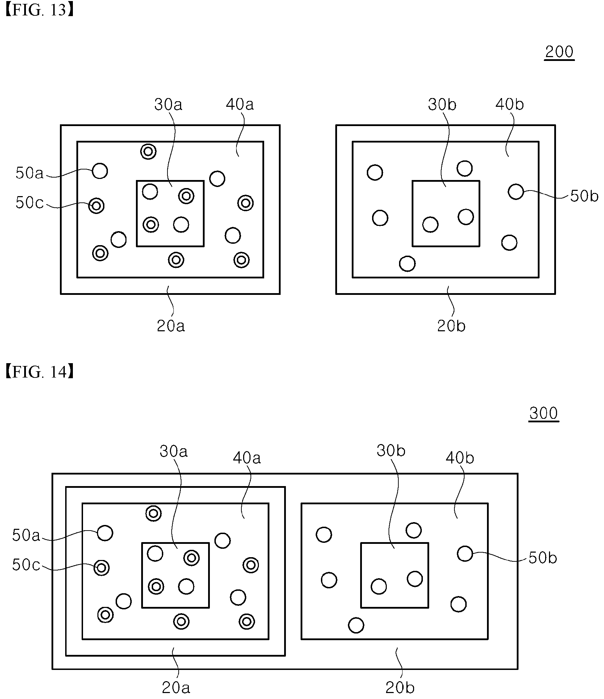

FIG. 13 is a schematic plan view illustrating a light emitting device 200 according to another embodiment of the present disclosure.

Referring to FIG. 13, the light emitting device 200 according to this embodiment is generally similar to the light emitting device 100 described with reference to FIGs. 8A and 8B, except that a first housing 20a and a second housing 20b are spaced apart from each other. The first housing 20a and the second housing 20b may be formed through different processes from each other, and thus, material selections of the first and second housings 20a and 20b may be free. Accordingly, the first housing 20a and the second housing 20b may be formed of a material suitable for a first light emitting diode chip 30a and a second light emitting diode chip 30b, respectively. For example, the first housing 20a may be formed of EMC, and the second housing may be formed of PCT.

Furthermore, molding members 40a and 40b may also be formed of a material suitable for the first light emitting diode chip 30a and the second light emitting diode chip 30b, respectively. For example, a first molding member 40a may be formed of silicone including methyl-based silicone as a main component, and a second molding member 40b may be formed of silicone including phenyl-based silicone as a main component.

FIG. 14 is a schematic plan view illustrating a light emitting device 300 according to another embodiment of the present disclosure.

Referring to FIG. 14, the light emitting device 300 according to this embodiment is generally similar to the light emitting device 100 described with reference to FIGs. 8A and 8B, except that a first housing 20a is surrounded by a second housing 20b. The first housing 20a may be formed first, and the second housing 20b may be formed to surround the first housing 20a, or the second housing 20b may be formed first, and the first housing 20a may be formed within the second housing 20b. A material of each of the first housing 20a and the second housing 20b may be selected to suit a first light emitting diode chip 30a and a second light emitting diode chip 30b. For example, the first housing 20a may be formed of EMC, and the second housing 20b may be formed of PCT.

Furthermore, molding members 40a and 40b may also be formed of a material suitable for the first light emitting diode chip 30a and the second light emitting diode chip 30b, respectively. For example, a first molding member 40a may be formed of silicone including methyl-based silicone as a main component, and a second molding member 40b may be formed of silicone including phenyl-based silicone as a main component.

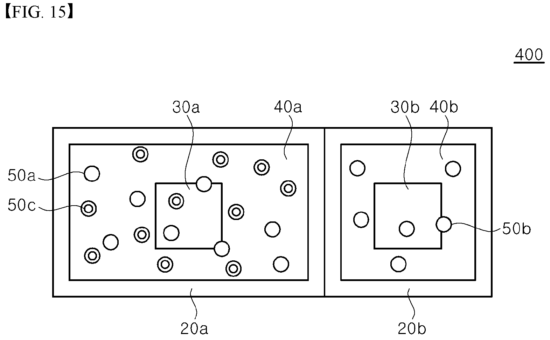

FIG. 15 is a schematic plan view illustrating a light emitting device 400 according to another embodiment of the present disclosure.

Referring to FIG. 15, the light emitting device 400 according to this embodiment is generally similar to the light emitting device 100 described with reference to FIGs. 8A and 8B, except that relative sizes of a first housing 20a and a second housing 20b are different. As illustrated in FIG. 15, the first housing 20a may be larger than the second housing 20b, and thus, more phosphors may be disposed within a cavity of the first housing 20a, and light emitted from a first light emitting diode chip 30a may be wavelength-converted more than light emitted from a second light emitting diode chip 30b.

According to the embodiments of the present disclosure, a plurality of light emitting diode chips is employed to maximize a wavelength conversion efficiency by considering a wavelength conversion efficiency of each of phosphors having different excitation spectra from one another. In addition, when different types of phosphors are mixed, the phosphors to be mixed may be selected to prevent light emitted from one phosphor from being wavelength-converted with low efficiency by another phosphor. For example, a red phosphor is mixed with a blue phosphor rather than mixed with a green phosphor, thereby suppressing a decrease in luminous efficiency.

According to the embodiments of the present disclosure, the wavelength conversion efficiency may be maximized, and further, optimal housing materials and molding materials may be selected for each light emitting diode chip, thereby significantly increasing light emission luminance compared to a light emitting device according to a prior art.

The light emitting devices 100, 200, 300, and 400 of the present disclosure may be used for lighting, and thus, may be mounted in a lighting apparatus. In particular, by employing the light emitting devices of the present disclosure, a lighting apparatus emitting white light with high efficiency similar to sunlight may be provided.

Although various embodiments of the present invention have been described above, the present invention is not limited to these embodiments, and may be modified in various ways. In addition, elements introduced in a specific embodiment may be applied to other embodiments without departing from the spirit of the invention.

## Claims

1. A light emitting device, comprising:
a first light emitting diode chip emitting light of a first peak wavelength;
a second light emitting diode chip emitting light of a second peak wavelength that is longer than the first peak wavelength;
a first wavelength conversion material disposed over the first light emitting diode chip and converting a wavelength of light emitted from the first light emitting diode chip; and
a second wavelength conversion material disposed over the second light emitting diode chip and converting a wavelength of light emitted from the second light emitting diode chip, wherein:
a peak wavelength of an excitation spectrum of the first wavelength conversion material is closer to the first peak wavelength than to the second peak wavelength,
a peak wavelength of an excitation spectrum of the second wavelength conversion material is closer to the second peak wavelength than to the first peak wavelength,
light incident from the first light emitting diode chip to the second wavelength conversion material is blocked, and
light incident from the second light emitting diode chip to the first wavelength conversion material is blocked.

2. The light emitting device of claim 1, further comprising:
a third wavelength conversion material disposed over the first light emitting diode chip, wherein:
the third wavelength conversion material converts wavelengths of light emitted from the first light emitting diode chip and light emitted from the first wavelength conversion material, and
a peak wavelength of an excitation spectrum of the third wavelength conversion material is closer to a peak wavelength of an emission spectrum of the first wavelength conversion material than to the first peak wavelength.

3. The light emitting device of claim 2, wherein:
the first wavelength conversion material is a blue phosphor,
the second wavelength conversion material is a green or yellow phosphor, and
the third wavelength conversion material is a red phosphor.

4. The light emitting device of claim 1, wherein:
the first peak wavelength is in a range of 410 nm to 440 nm, and
the second peak wavelength is in a range of 440 nm to 470 nm.

5. The light emitting device of claim 1, further comprising:
a first housing having a first cavity; and
a second housing having a second cavity, wherein:
the first light emitting diode chip is disposed in the first cavity of the first housing,
the second light emitting diode chip is disposed in the second cavity of the second housing, and
the first cavity and the second cavity are spaced apart from each other.

6. The light emitting device of claim 5, wherein:
the first housing is formed of an epoxy molding compound, and
the second housing is formed of PCT (Polyester Polycyclohexylenedimethylene Terephthalate).

7. The light emitting device of claim 5, further comprising:
a first molding member disposed in the first cavity; and
a second molding member disposed in the second cavity, wherein:
the first wavelength conversion material is distributed in the first molding member, and
the second wavelength conversion material is distributed in the second molding member.

8. The light emitting device of claim 7, wherein:
the first molding member includes silicone with methyl-based silicone as its main component, and
the second molding member includes silicone with phenyl-based silicone as its main component.

9. The light emitting device of claim 7, further comprising:
a third wavelength conversion material disposed in the first molding member, wherein:
the third wavelength conversion material converts wavelengths of light emitted from the first light emitting diode chip and light emitted from the first wavelength conversion material, and
a peak wavelength of an excitation spectrum of the third wavelength conversion material is closer to the peak wavelength of the emission spectrum of the first wavelength conversion material than to the first peak wavelength.

10. The light emitting device of claim 9,
wherein the peak wavelength of the emission spectrum of the third wavelength conversion material is longer than a peak wavelength of an emission spectrum of the second wavelength conversion material.

11. The light emitting device of claim 9, wherein:
the first wavelength conversion material is a blue phosphor,
the second wavelength conversion material is a green or yellow phosphor, and
the third wavelength conversion material is a red phosphor.

12. The light emitting device of claim 5,
wherein the first housing is coupled to the second housing.

13. The light emitting device of claim 12,
wherein the first housing is surrounded by the second housing.

14. The light emitting device of claim 5,
wherein the first housing is spaced apart from the second housing.

15. The light emitting device of claim 5,
wherein the first housing and the second housing have different areas from each other.

16. A light emitting device, comprising:
a first light emitting unit comprising a first light emitting diode chip and a first wavelength conversion material; and
a second light emitting unit comprising a second light emitting diode chip and a second wavelength conversion material, wherein:
the first light emitting diode chip emits light of a first peak wavelength,
the second light emitting diode chip emits light of a second peak wavelength that is longer than the first peak wavelength,
the first light emitting unit emits first mixed color light having a color coordinate positioned below the Planckian locus on a CIE color coordinate system,
the second light emitting unit emits second mixed color light having a color coordinate positioned above the Planckian locus on the CIE color coordinate system, and
the light emitting device emits light in which the first mixed color light and the second mixed color light are mixed.

17. The light emitting device of claim 16, further comprising:
a third wavelength conversion material, wherein:
the third wavelength conversion material converts wavelengths of light emitted from the first light emitting diode chip and light emitted from the first wavelength conversion material, and
a peak wavelength of an excitation spectrum of the third wavelength conversion material is closer to a peak wavelength of an emission spectrum of the first wavelength conversion material than to the first peak wavelength.

18. The light emitting device of claim 17, wherein:
the first wavelength conversion material is a blue phosphor,
the second wavelength conversion material is a green or yellow phosphor, and
the third wavelength conversion material is a red phosphor.

19. A lighting apparatus, comprising:
a light emitting device,
the light emitting device, comprising:
a first light emitting diode chip emitting light of a first peak wavelength;
a second light emitting diode chip emitting light of a second peak wavelength that is longer than the first peak wavelength;
a first wavelength conversion material disposed over the first light emitting diode chip and converting a wavelength of light emitted from the first light emitting diode chip; and
a second wavelength conversion material disposed over the second light emitting diode chip and converting a wavelength of light emitted from the second light emitting diode chip, wherein:
a peak wavelength of an excitation spectrum of the first wavelength conversion material is closer to the first peak wavelength than to the second peak wavelength,
a peak wavelength of an excitation spectrum of the second wavelength conversion material is closer to the second peak wavelength than to the first peak wavelength,
light incident from the first light emitting diode chip to the second wavelength conversion material is blocked, and
light incident from the second light emitting diode chip to the first wavelength conversion material is blocked.

20. The lighting apparatus of claim 19, further comprising:
a third wavelength conversion material disposed over the first light emitting diode chip, wherein:
the third wavelength conversion material converts wavelengths of light emitted from the first light emitting diode chip and light emitted from the first wavelength conversion material, and
a peak wavelength of an excitation spectrum of the third wavelength conversion material is closer to a peak wavelength of an emission spectrum of the first wavelength conversion material than to the first peak wavelength.
